# EUROPEAN PATENT APPLICATION

(11) **EP 2 432 030 A2**
(43) Date of publication of application: **21.03.2012**
(21) Application number: 11181047.9
(22) Date of filing: 13.09.2011
(51) Int. Cl.: H01L 31/042

(54) **Solar cell module and method of manufacturing the same**

(30) Priority: 17.09.2010 JP 2010208719
(71) Applicant: Fuji Electric Co., Ltd., Kawasaki-shi 210-9530 (JP)
(72) Inventor: Higashidate, Makoto, Kawasaki-shi, 210-9530 (JP); Hitomi, Miyako, Kawasaki-shi, 210-9530 (JP); Tanda, Masayuki, Kawasaki-shi, 210-9530 (JP)
(74) Representative: MERH-IP Matias Erny Reichl Hoffmann

(57) **Abstract**

Disclosed is a technique capable of facilitating a process of integrating a solar cell module with a support member.

An aspect of the invention provides a solar cell module with a pressure sensitive adhesive member. The solar cell module with a pressure sensitive adhesive member includes a flexible solar cell module and a pressure sensitive adhesive member that is arranged so as to cover at least a portion of the rear surface of the flexible solar cell module. The storage modulus G' of the pressure sensitive adhesive member is from 0.02 MPa to 0.7 MPa under the use conditions of the flexible solar cell module. Another aspect of the invention provides a support member integrated solar cell module including a solar cell module with a pressure sensitive adhesive member and a support member integrated with each other.

## Description

### BACKGROUND OF THE INVENTION

### 1. Field of the Invention

The present invention relates to a solar cell module and a method of manufacturing the same. More particularly, the present invention relates to a solar cell module with a pressure sensitive adhesive member, a support member integrated solar cell module, and methods of manufacturing them.

### 2. Description of the Related Art

Solar cells that generate power using sunlight are mainly installed on the roof of the building. When the solar cells are installed on the roof of the existing building, a load that is not considered in the design of the building is added to the roof. It may be difficult to install the solar cells on the roof due to a load caused by the weight or mass of the solar cells. Specifically, when the solar cells are additionally installed on the roof of the existing building, a load limit is about 10 kg/m², which is mass per unit area on the upper surface of the roof. The mass per unit volume of a general solar cell module is more than 10 kg/m². This is because most of the solar cell panels using a photoelectric conversion layer which is made of, for example, a single crystalline, polycrystalline, amorphous, or compound-based semiconductor are generally laminated on a thick glass substrate to form a module, in order to be suitable for various kinds of standards, for example, the standard of wind resistance. In addition, the solar cell module using the glass substrate requires an additional member, such as a frame for protecting the periphery of the solar cell module or a mount for fixation. For this reason, it may be difficult to install the solar cell module using the glass substrate on the roof of the existing building.

Problems other than the load arise in the solar cell module using the glass substrate. One of the problems is that the overall shape of the solar cell module is limited by the shape of the glass substrate. For example, in many cases, the solar cell module using the glass substrate has a flat plate shape. When the flat solar cell module is installed on the curved roof, a plurality of solar cell modules is installed along the curved surface. The solar cell modules installed in this way form a polygonal surface, which is not a curved surface.

As a solar cell module for solving these problems, a flexible solar cell module has been known. For example, the flexible solar cell module is manufactured by combining a photoelectric conversion layer, such as a thin film semiconductor, with a flexible substrate, such as a resin substrate. For example, one of the characteristics of this structure is that the weight of the flexible solar cell module is reduced. In practice, in the flexible solar cell module using a polyimide substrate, mass per unit area is about 1 kg/m². That is, the weight of the flexible solar cell module is very small. For example, the weight of the flexible solar cell module is about one-tenth or less than that of the solar cell module using the glass substrate. Another characteristic of this structure is that the flexible solar cell module can be rolled to have a small size and then carried, or it can be installed so as to be curved along the curved surface.

Japanese Patent Application Laid-Open (JP-A) No. 6-85303 discloses a method of installing a flexible solar cell module (flexible solar cell panel) on the roof using bonding by an adhesive. In the disclosed method, for example, an adhesive including silicon is used to install the flexible solar cell module (for example, see JP-A No. 6-85303; paragraph 0018).

However, in practice, when the flexible solar cell module is integrated with a support member, such as an external member (hereinafter, referred to as a "roofing material"), of the roof using the adhesive, many problems occur in terms of cost and operation. Specifically, for the cost problem, it is difficult to reduce the amount of adhesive used in terms of joint strength. In addition, in some cases, since an expiration data is set to the adhesive, it is difficult to reduce costs. The operation problems are divided into an operation time problem, a workload problem, and an operation characteristic problem. Among them, a typical example of the operation time problem is that a predetermined curing time is required in the bonding method using the adhesive. The waiting time for the curing time depends on the time required for the chemical change of the adhesive and it is necessary to ensure a given time margin. As a result, the waiting time longer than the actual curing time of the adhesive is required. For example, when a moisture-curable adhesive is used, a waiting time of one week is required in order to bonding the entire rear surface of the solar cell module. A typical example of the workload problem is that the operator needs to work precisely. For example, the operate needs to have considerable experience in applying an optimal amount of adhesive to reduce the consumption of the adhesive or prevent an increase in the curing time while ensuring joint strength. Another example of the workload problem is that, when two types of liquid adhesives are used for bonding, the relative mixture ratio of the two types of liquid adhesives needs to be accurately adjusted in order to ensure desired adhesion strength. When these precise operations are performed in the construction field, a large workload is applied to the operator. A typical example of the operation characteristic problem is that, when the adhesive is used, it is very difficult to remove the cured adhesive, once the adhesive is cured. In addition, temporary fixation, which is an operation peculiar to adhesion, causes an operational problem. When temporary fixation is needed in adhesion, for example, additional operations of waiting for the curing of the adhesive and then removing a fixing tool are required. Therefore, it is difficult to reduce the workload of adhesion.

### SUMMARY OF THE INVENTION

The invention has been made in view of the above-mentioned problems. That is, an object of the invention is to provide a technique capable of facilitating an operation of integrating a flexible solar cell module with a support member, thereby contributing to the application of the flexible solar cell module to various purposes.

In order to achieve the object, in the invention, as a method of integrating a flexible solar cell module with a support member, bonding using a pressure sensitive adhesive member (hereinafter, simply referred to as "pressure sensitive adhesion") is used. When the pressure sensitive adhesion is used, high operation accuracy is not required in order to integrate the flexible solar cell module with the support member. That is, in the case of the pressure sensitive adhesion, the bonding performance is less affected by the difference between the operations or the difference in operation between the operators than adhesion. In addition, when the pressure sensitive adhesion is used, the operation time is significantly reduced as compared to the case in which adhesion is used, and temporary fixation is not needed. The reason is that, when a pressure sensitive adhesive member is used, strong bonding is obtained immediately after the pressure sensitive adhesive member is contacted. In addition, it is ease to remove the flexible solar cell module bonded to the support member by the pressure sensitive adhesion for a certain reason, as compare to the case in which the adhesive is used.

The inventors examined various technical problems in order to sufficiently improve practicality in terms of a reduction in workload and a bonding performance when the flexible solar cell module was bonded to the support member by pressure sensitive adhesion. Among the technical problems, the inventors paid attention to the point that the bonding performance by the pressure sensitive adhesive member was greatly affected by the temperature. The pressure sensitive adhesive member for integrating the flexible solar cell module with the support member needs to have a sufficient bonding performance under the use conditions of the flexible solar cell module. In the use conditions, since the solar cell is generally installed outdoors, a wide temperature range from a low temperature to a high temperature is set. Therefore, in order to improve the practicality of the bonding performance, the bonding performance needs to be examined in the temperature range.

Direct indexes for the bonding performance include the peel strength of bonded assemblies at 180-degree peel and tensile lap-shear strength. During the measurement of the strength, when a test piece in which the flexible solar cell module and the support member are integrated with each other by the pressure sensitive adhesive member is used, the measured strength value or a peeling action is a direct index that reflects the actual structure. In the following description, the two strength values are respectively referred to as "180-degree peel strength" and "tensile shear strength," and are collectively referred to as "joint strength."

The inventors conducted experiments for measuring the joint strength of the test piece in which the flexible solar cell module and the support member were integrated with each other by the pressure sensitive adhesive member. The inventors found from the experiments that the shear storage modulus G' (hereinafter, referred to as a "storage modulus G"') of the pressure sensitive adhesive member was an effective measure for obtaining a sufficient bonding performance. The dynamic viscoelasticities of the pressure sensitive adhesive members, which are selection candidates, are measured and the storage modulus G' of each pressure sensitive adhesive member is measured. The measurement makes it possible to determine whether each of the pressure sensitive adhesive members, which are selection candidates, has sufficient strength in the joint strength test using the test piece.

In addition, the inventors examined the numerical range of the storage modulus G' of the pressure sensitive adhesive member that obtained good results in the joint strength test using the test piece. In order to integrate the flexible solar cell module with the support member, it is effective to use the numerical range of the storage modulus G' as a standard for appropriately selecting the pressure sensitive adhesive member or a criterion for manufacturing the pressure sensitive adhesive member suitable for the use conditions of the flexible solar cell module which is integrated with the support member.

According to an aspect of the invention, there is provided a solar cell module with a pressure sensitive adhesive member. That is, according to an aspect of the invention, there is provided a solar cell module with a pressure sensitive adhesive member including: a flexible solar cell module; and a pressure sensitive adhesive member that is provided on a rear surface of the flexible solar cell module opposite to a light receiving surface so as to cover at least a portion of the rear surface. A storage modulus G' of the pressure sensitive adhesive member is from 0.02 MPa to 0.7 MPa under the use conditions of the flexible solar cell module.

According to another aspect of the invention, there is provided a support member integrated solar cell module. That is, according to another aspect of the invention, there is provided a support member integrated solar cell module including: a support member including a support surface; a flexible solar cell module including a light receiving surface and a rear surface opposite to the light receiving surface; and a pressure sensitive adhesive member that is provided in at least a portion of the rear surface and has a storage modulus G' is from 0.02 MPa to 0.7 MPa under the use conditions of the flexible solar cell module. The flexible solar cell module and the support member are integrated with each other by the pressure sensitive adhesive member with the rear surface facing the support surface.

According to still another aspect of the invention, there is provided a method of manufacturing a solar cell module with a pressure sensitive adhesive member. That is, according to still another aspect of the invention, there is provided a method of manufacturing a solar cell module with a pressure sensitive adhesive member including: arranging a pressure sensitive adhesive member on a rear surface of a flexible solar cell module opposite to a light receiving surface so as to cover at least a portion of the rear surface. A storage modulus G' of the pressure sensitive adhesive member is from 0.02 MPa to 0.7 MPa under the use conditions of the flexible solar cell module.

According to yet another aspect of the invention, there is provided a method of manufacturing a support member integrated solar cell module. That is, according to yet another aspect of the invention, there is provided a method of manufacturing a support member integrated solar cell module including: arranging a solar cell module including a pressure sensitive adhesive member that is provided on a rear surface of a flexible solar cell module opposite to a light receiving surface so as to cover at least a portion of the rear surface such that the pressure sensitive adhesive member is exposed and the exposed adhesive member faces a support surface of a support member; and pressing the solar cell module with a pressure sensitive adhesive member against the support member. A storage modulus G' of the pressure sensitive adhesive member is from 0.02 MPa to 0.7 MPa under the use conditions of the flexible solar cell module. 15. According to still yet another aspect of the invention, there is provided a method of manufacturing a support member integrated solar cell module including: arranging a pressure sensitive adhesive member on a support surface of a support member; arranging a flexible solar cell module relative to the exposed pressure sensitive adhesive member such that at least a portion of a rear surface of the flexible solar cell module opposite to a light receiving surface comes into contact with the pressure sensitive adhesive member; and pressing the solar cell module with a pressure sensitive adhesive member against the support member. A storage modulus G' of the pressure sensitive adhesive member is from 0.02 MPa to 0.7 MPa under the use conditions of the flexible solar cell module.

In each of the above-mentioned aspects of the invention, the pressure sensitive adhesion is one kind of bonding and is characterized by applying low pressure to bond an object in a short time at room temperature without using, for example, water, a solvent, or heat. That is, the pressure sensitive adhesion indicates general bonding using the stickiness of a given pressure sensitive adhesive (PSA). It is noted that the mechanism of the "pressure sensitive adhesion" is essentially different from the mechanism of "structural adhesion" in which an adherend is bonded by curing from the non-cured state of an adhesive, that is, "adhesion." In the adhesion, bonding is performed by a variation in the property of the adhesive due to curing, such as the drying of water or a solvent included in the adhesive, the chemical reaction of a material forming the adhesive, such as a cross-linking reaction or a polymerization reaction, or a significant increase in the viscosity of the adhesive by cooling. In contrast, in the pressure sensitive adhesion, a variation in the property of the pressure sensitive adhesive is not necessarily needed in order to perform bonding. The pressure sensitive adhesive does not depend on a variation in property, such as curing, and includes a material having stickiness, specifically, tact force, joining force, and cohesive force. Therefore, the adhesion and the pressure sensitive adhesion indicate different bonding actions based on different mechanisms and the pressure sensitive adhesion is clearly discriminated from the adhesion. In the invention, the term "bonding" means attaching the surfaces of the same kind or different kinds of solid objects to integrate the surfaces or the integrated state of the surfaces and includes the pressure sensitive adhesion and the adhesion. In addition, in the invention, bonding or integrating operation and process and a bonded or integrated state do not mean that the bonded or integrated object cannot be separated or removed in a post-process.

The PSA member means a member that is made of any material including a pressure sensitive adhesive and has an arbitrary thickness, and provides a bonding action by the pressure sensitive adhesive to arbitrary objects that come into contact with both surfaces forming the overall thickness of the PSA member. The PSA member is typically a single-layer or multi-layer film or layer. The PSA member may uniformly extend, may be provided only in a given region, or may be arranged such that regions in which the PSA member is provided and regions in which the PSA member is not provided are alternately arranged. In some cases, the PSA member includes, for example, a sheet-shaped or tape-shaped base material other than the pressure sensitive adhesive. Hereinafter, the base material is referred to as a base sheet. The PSA member in which the pressure sensitive adhesive is directly coated on both surfaces of the base sheet without stickiness or it is coated on both surface of the base sheet with other layers interposed therebetween has a laminated structure of a pressure sensitive adhesive, a base sheet, and a pressure sensitive adhesive from one surface to the other surface. In the PSA member with the laminated structure, in the invention, the overall structure in which the pressure sensitive adhesive layers are bonded to both surfaces of the base sheet is called the PSA member. Most of the so-called double-sided PSA tapes have the structure including the base sheet and the pressure sensitive adhesives provided on both surfaces of the base sheet. In addition, a layer or a film including only the pressure sensitive adhesive having a single-layer sheet or tape shape is included in the PSA member according to the invention.

In the invention, the pressure sensitive adhesive means a material with stickiness. The pressure sensitive adhesive includes various kinds of single elements or mixtures. That is, in each of the above-mentioned aspects of the invention, the pressure sensitive adhesive includes, for example, a solvent PSA, a water borne PSA, a hot melt PSA, a calendered PSA, a chemical reaction PSA, a rubber PSA, an acrylic PSA, and a silicone PSA. In addition, the pressure sensitive adhesive includes any tackifier. Further, in each of the above-mentioned aspects of the invention, after the pressure sensitive adhesive is bonded, it is changed in any way. That is, in the invention, as a typical example, the pressure sensitive adhesive includes a non-curable PSA, that is, a material that is hardly changed over time.

In the invention, the support member means any object that provides a function of substantially supporting the flexible solar cell module from one surface. That is, the support member is generally an object with which the flexible solar cell module is integrated. Among outer surfaces of the support member, a surface facing the flexible solar cell module is particularly referred to as a support surface. For example, in the invention, as the support member, a roofing material of the building is selected. In this case, the support surface includes the outer surface of the roofing material. However, the support member is not necessarily fixed to, for example, the building. Therefore, the support member includes a steel plate or a sheet.

In the invention, in particular, the flexible solar cell module means any solar cell module having flexibility as a whole. In the typical flexible solar cell module, for example, a thin film semiconductor or an organic photoelectric conversion layer is formed on or above a flexible substrate. The kind of solar cell using the thin film semiconductor is not particularly limited, but the solar cell using the thin film semiconductor includes a solar cell having a single nip junction or a pn junction and a tandem solar cell that uses a plurality of junctions and includes any photoelectric conversion layer. The thin film semiconductor is any semiconductor whose representative example is silicon or germanium. The semiconductor in the photoelectric conversion layer is, for example, amorphous or microcrystalline. When the solar cell using an organic material is used, a material forming the photoelectric conversion layer is not particularly limited. In addition, any flexible substrate including a resin film substrate or a metal thin plate substrate, such as, a stainless thin plate, may be used as the flexible substrate.

In addition, in the invention, the flexible solar cell module includes an assembly having additional components for arbitrary purposes. The additional components include, for example, a sealing resin for improving weather resistance or a reinforcing member for ensuring strength while maintaining flexibility. In the assemblies having the additional components, the entire assembly including the flexible solar cell module is called the flexible solar cell module.

In the invention, the storage modulus G' of the PSA member is measured by the measurement of the dynamic viscoelasticity by a rheometer. In this case, a plate/plate-type, that is, paralleled-plate-type geometry measurement tool is used and both surfaces of the PSA member are interposed between two opposite circular plates. The two circular plates are coaxially arranged such that normal lines (central axes) passing through the centers of the two circular plates overlap each other, and can be rotated about the central axes relative to each other. A vibration-rotational displacement that is vibrated at a given frequency in the circumferential direction is applied to the PSA member by the two circular plates. Vibratory torque that is vibrated in both surfaces of the PSA member at the same frequency in the circumferential direction according to the vibration-rotational displacement is measured. In addition, predetermined force (normal force) is applied to the PSA member in the thickness direction. The calculated storage modulus G' is calculated by dividing the amplitude of a component having the same phase as the rotational displacement in the shear stress which is calculated from the measured vibratory torque by the amplitude of the vibratory shear strain which is calculated from the vibration-rotational displacement and the thickness of the PSA member. When the storage modulus G' is measured, a shear loss modulus G" is also calculated and tan δ is also calculated from G"/G'.

The value of the storage modulus G' greatly varies depending on the PSA member and depends on various conditions during measurement. For example, the value of the storage modulus G' strongly depends on the temperature. In the invention, the temperature range in which the value of the storage modulus G' can be examined is determined so as to include at least the temperature range of the use conditions of the PSA member, that is, the temperature range of the use conditions of the flexible solar cell module. As another example, the value of the storage modulus G' also depends on the frequency of mechanical vibration during measurement. In the invention, the frequency of vibration is fixed to 1.0 Hz. This is because it is difficult to perform comparison even when the frequency is unnecessarily changed. In addition, there are conditions that have an effect on the value of the storage modulus G'. The conditions will be described in detail in the following embodiments of the invention.

The use conditions of the flexible solar cell module mean conditions that are considered in the situation in which the flexible solar cell module is installed in order to generate power. The use conditions include, for example, conditions that reflect the state of the flexible solar cell module that is installed so as to be exposed to direct sunlight and generates power in the summer or the state of the flexible solar cell module that is installed and stops generating power in the night in the winter and conditions (for example, operation warranty conditions) that are determined considering these states. Among the use conditions, the temperature is important. For example, the temperature range of the use conditions is from -20°C to 85°C.

Some aspects of the invention provide a solar cell module with a PSA member that will be integrated with a support member and uses the essential properties of a flexible solar cell module, such as a light weight and flexibility, a flexible solar cell module that is integrated with the support member by a PSA member, and methods of manufacturing them. In this way, for example, it is possible to facilitate an operation of installing the flexible solar cell module on the upper surface of the roof of the existing building.

### BRIEF DESCRIPTION OF THE DRAWINGS

Fig. 1 is a cross-sectional view schematically illustrating the structure of a solar cell module with a pressure sensitive adhesive member according to an embodiment of the invention;
Fig. 2 is a cross-sectional view schematically illustrating the structure of a flexible solar cell module according to an embodiment of the invention;

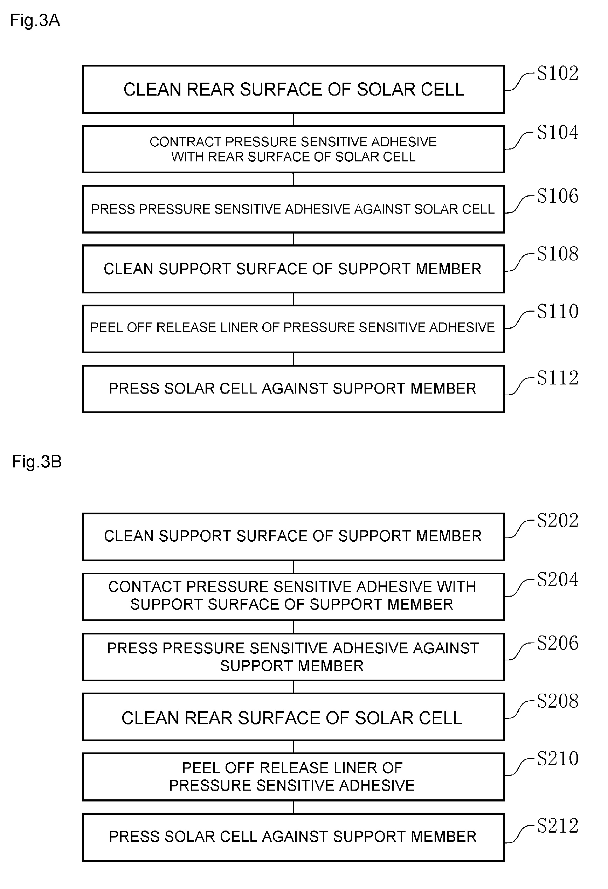

Figs. 3A and 3B are flowcharts illustrating a method of manufacturing a support member integrated solar cell module according to an embodiment of the invention: particularly, Fig. 3A is a flowchart illustrating a manufacturing method (first manufacturing method) of manufacturing a solar cell module with a pressure sensitive adhesive member and integrating the solar cell module with a pressure sensitive adhesive member with a support member; and Fig. 3B is a flowchart illustrating a manufacturing method (second manufacturing method) of bonding a flexible solar cell module to the pressure sensitive adhesive member arranged on the support member, thereby integrating the flexible solar cell module with the support member;
Fig. 4A is a cross-sectional view schematically illustrating the structure of a solar cell module with a pressure sensitive adhesive member according to an embodiment of the invention;
Fig. 4B is a plan view illustrating the structure of the solar cell module with a pressure sensitive adhesive member;
Fig. 5 is a cross-sectional view schematically illustrating the structure of a support member integrated solar cell module in a manufacturing method according to an embodiment of the invention during the manufacture of the support member integrated solar cell module; and
Fig. 6 is a graph illustrating the storage modulus G' of each sample of the pressure sensitive adhesive member measured at each temperature in an embodiment of the invention.

### DESCRIPTION OF THE PREFERRED EMBODIMENTS

Hereinafter, exemplary embodiments of the invention will be described. In the following description, the same portions or components in all of the drawings are denoted by the same reference numerals as long as they are not particularly referred to. In the drawings, the scale of each element according to each embodiment is adjusted to have a recognizable size.

The invention is implemented by some typical aspects. The typical aspects are implemented as a flexible solar cell module (solar cell module with a pressure sensitive adhesive member) including a pressure sensitive adhesive member (hereinafter, simply referred to as a PSA member) and a method of manufacturing the flexible solar cell module. In the invention, other typical aspects are implemented as a flexible solar cell module (support member integrated solar cell module) having a support member integrated therewith and a method of manufacturing the flexible solar cell module. All of the typical aspects will be described in detail as a portion of or the entire first embodiment according to the invention.

### <First embodiment>

### [Structure]

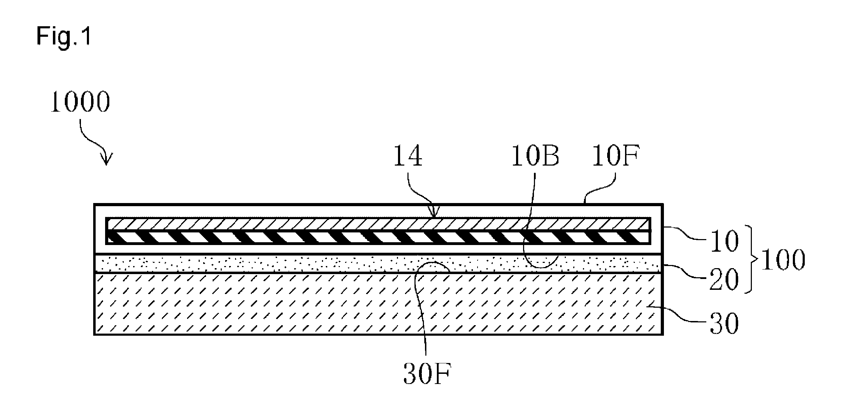

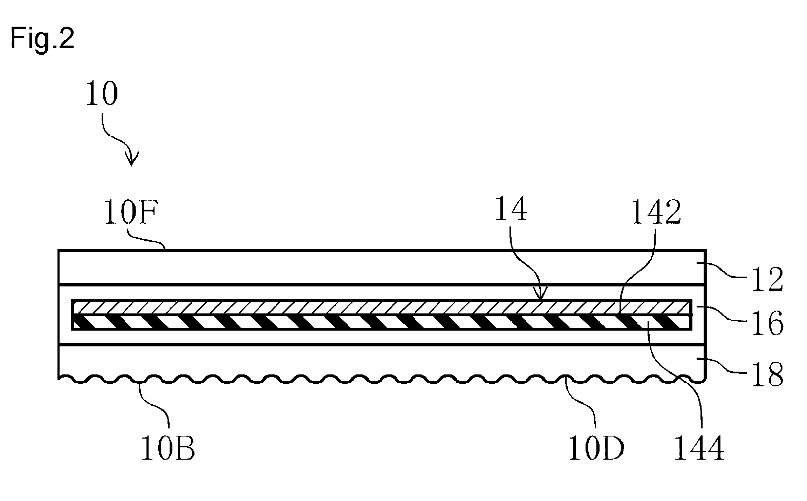

Fig. 1 is a cross-sectional view schematically illustrating the structure of a support member integrated solar cell module according to this embodiment. Fig. 2 is a cross-sectional view schematically illustrating the structure of a flexible solar cell module according to this embodiment. As shown in Fig. 1, a support member integrated solar cell module 1000 according to this embodiment includes a flexible solar cell module 10, a PSA member 20, and a support member 30. Among them, the flexible solar cell module 10 includes a light receiving surface 10F and a rear surface 10B and the support member 30 includes a support surface 30F. The flexible solar cell module 10 and the support member 30 are integrated with each other by the PSA member 20 with the rear surface 10B facing the support surface 30F.

As shown in Fig. 2, the flexible solar cell module 10 includes a solar cell element 14 that is sealed or enclosed by a sealing resin 16. A thin-film semiconductor solar cell including a photoelectric conversion layer 142 and a flexible substrate 144 is used as the solar cell element 14. For example, a resin substrate, such as a polyimide substrate, or a metal thin plate, such as a stainless thin plate, is used as the flexible substrate 144 in order to give flexibility to the entire flexible solar cell module 10. In addition, the photoelectric conversion layer 142 may be a thin-film semiconductor photoelectric conversion layer made of, for example, amorphous silicon, microcrystalline silicon, or amorphous silicon germanium. In addition to an inorganic semiconductor film, such as a silicon film, for example, an organic thin film or a dyesensitized thin film may be used as the photoelectric conversion layer 142. The photoelectric conversion layer 142 may have any structure with a plurality of junctions as well as a single junction.

Fluorine-based resin sheets 12 and 18 are provided on the light receiving surface 10F and the rear surface 10B of the flexible solar cell module 10. In particular, concave and convex portions are formed on a surface, serving as the rear surface 10B, of the fluorine-based resin sheet 18 provided on the rear surface 10B. The concave and convex portions are formed so as to have a depth of about 130 µm. A process of modifying the surface using plasma (plasma treatment) or a corona discharge treatment is performed on the rear surface 10B in order to reliably perform bonding using an adhesive in the subsequent process. Materials forming the sealing resin 16 and the fluorine-based resin sheets 12 and 18 are appropriately selected such that the flexibility of the flexible solar cell module 10 is not hindered. The fluorine-based resin sheet 12 and the sealing resin 16 close to the light receiving surface 10F are made of a translucent material so as not to hinder the incidence of light on the photoelectric conversion layer 142.

In Fig. 2, the concave and convex portions provided on the rear surface 10B, which is also the surface of the fluorine-based resin sheet 18, are formed by a process (embossing process) that applies heat and pressure to form concave portions 10D using, for example, embossing when the flexible solar cell module 10 is manufactured. In Fig. 2, the concave and convex portions are provided on only one surface of the fluorine-based resin sheet 18, but the concave and convex portions may be formed in other ways. For example, the fluorine-based resin sheet 18 may be corrugated with a substantially uniform thickness and the concave and convex portions may also be formed at the interface between the fluorine-based resin sheet 18 and the sealing resin 16. The concave and convex portions may also be formed on the surface of the fluorine-based resin sheet 12, which is the light receiving surface 10F, which is optional (not shown). The concave and convex portions provided on the front surface 10F may be formed on only one surface of the fluorine-based resin sheet 12 (not shown), or the fluorine-based resin sheet 12 may be corrugated with a substantially uniform thickness and the concave and convex portions may be formed at the interface between the fluorine-based resin sheet 12 and the sealing resin 16 (not shown). The concave and convex portions provided on the rear surface of the flexible solar cell module are for degassing in the process of sealing the flexible solar cell module (not shown). The depth of the concave and convex portions may be adjusted by changing the manufacturing conditions of the flexible solar cell module, that is, an embossing mold or embossing conditions.

Returning to Fig. 1, the PSA member 20 is a single-layer or multi-layer film or a layered member that includes a pressure sensitive adhesive and is made of an arbitrary material with an arbitrary thickness. The PSA member 20 provides a bonding action by pressure sensitive adhesion to both surfaces in the thickness direction. The PSA member 20 according to this embodiment is limited in a predetermined physical property range, which will be described below.

The support member 30 is an arbitrary body that provides a function of supporting the flexible solar cell module 10. Examples of the support member 30 include a plate, such as a steel plate, a sheet, such as a waterproof sheet, an outdoor tent film, and an external member, which is a roofing material of the existing building. As a representative example of the support member 30, a plate-shaped body is shown in Fig. 1. The support surface 30F is one surface of the support member 30 close to the flexible solar cell module 10. The support surface 30F supports the flexible solar cell module 10 from the side of the rear surface 10B. It is arbitrarily selected whether the support member 30 has flexibility.

### [Manufacturing method]

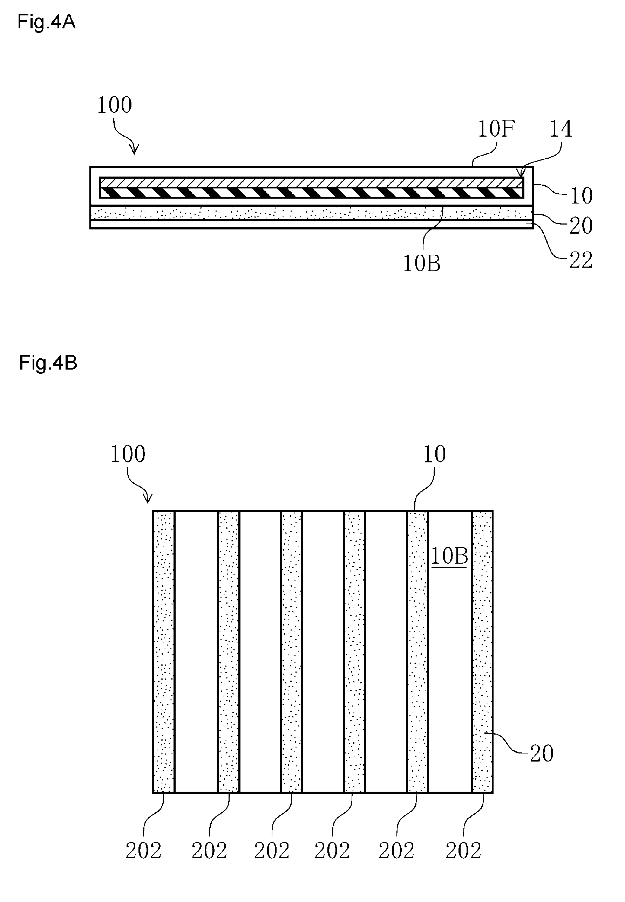

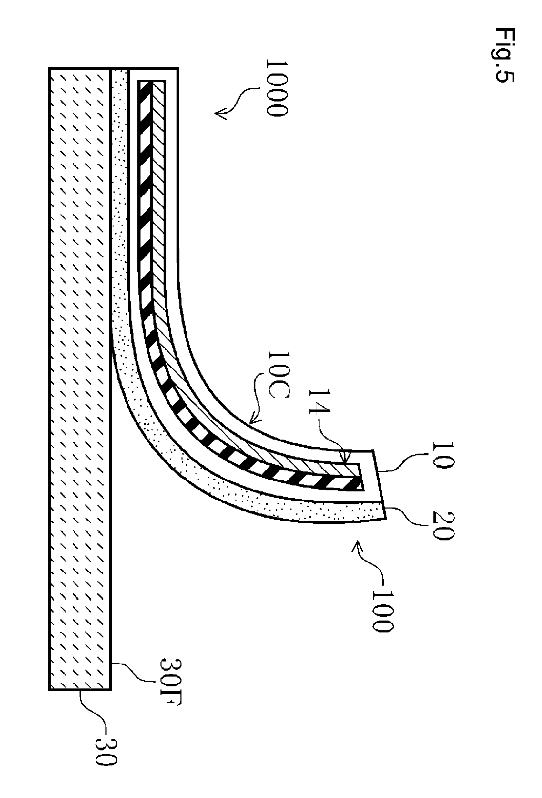

Next, a method of manufacturing the support member integrated solar cell module will be described with reference to Figs. 3A to 5. Figs. 3A and 3B are flowcharts illustrating the method of manufacturing the support member integrated solar cell module according to this embodiment. Fig. 3A shows a manufacturing method (first manufacturing method) that manufactures a solar cell module with a PSA member and then integrates the solar cell module with a PSA member with the support, and Fig. 3B shows a manufacturing method (second manufacturing method) that bonds the flexible solar cell module to the PSA member provided on the support member to integrate them. Fig. 4A is a plan view schematically illustrating the structure of the solar cell module with a PSA member according to this embodiment and Fig. 4B is a plan view illustrating the structure of the solar cell module with a PSA member. Fig. 5 is a cross-sectional view schematically illustrating the structure of the support member integrated solar cell module in the first manufacturing method according to this embodiment during the manufacture of the support member integrated solar cell module.

The method of manufacturing the support member integrated solar cell module according to this embodiment is mainly divided into two methods. In the first manufacturing method, the solar cell module 100 with a PSA member is manufactured and then the solar cell module 100 with a PSA member and the support member 30 are integrated with each other. In the second manufacturing method, first, the PSA member 20 is formed on the support member 30 and the PSA member 20 and the support member 30 are integrated with the flexible solar cell module 10. Next, each of the first and second manufacturing methods will be described.

In the first manufacturing method shown in Fig. 3A, the rear surface 10B of the flexible solar cell module 10 is cleaned (S102). In this case, a solvent, such as ethanol or acetone, is used according to the kind of contaminant adhered. Then, the PSA member 20 comes into contact with the rear surface 10B so as to cover at least a portion of the rear surface 10B of the flexible solar cell module 10 (S104). Then, the PSA member 20 is pressed against the solar cell (S106). At that time, the solar cell module 100 with a PSA member (Fig. 4A) is manufactured. In order for the pressure sensitive adhesive to protect an exposed surface (pressure sensitive adhesion surface) from a contaminant, such as dust, or unintended contact, a release liner 22 remains on the PSA member 20.

The details of the steps are appropriately adjusted in the implementation phase. The details of the steps are adjusted considering the detailed structure of the PSA member 20 or the flexible solar cell module 10. In this embodiment, as a typical example, a case in which the PSA member 20 is a so-called double-sided PSA tape will be described. In this case, when the PSA member 20 (double-sided PSA tape) is pressed against the rear surface 10B of the flexible solar cell module 10, a strong joining force is instantly obtained. This is because of the tact force of the PSA member 20.

The details of the steps (S102 to S106) are adjusted since the bonding performance of the PSA member 20 depends on the structure of the flexible solar cell module 10, particularly, the shape characteristics of the rear surface 10B. In this case, as a typical example, a case in which the concave and convex portions are formed on the rear surface 10B of the flexible solar cell module 10 will be described. As described above with reference to Fig. 2, when the concave and convex portions are provided on the rear surface 10B, only the contact between the PSA member 20 and the flexible solar cell module 10a is insufficient to obtain a good bonding performance. In this case, in the process (S104) in which the PSA member 20 is provided on the rear surface 10B, it is preferable to use a process of pressing the double-sided PSA tape against the flexible solar cell module 10 from the upper side of the release liner 22 using a squeegee (not shown). Compressive stress in the thickness direction and shear stress in a direction perpendicular to the thickness direction are applied to the PSA member 20 pressed by the squeegee. For example, when the PSA member 20 is pressed by a roller, the shear stress is not applied. When the PSA member 20 is pressed by the squeegee, the pressure sensitive adhesive of the PSA member 20, which is a double-sided PSA tape, gets into the concave portions 10D (Fig. 2) of the concave and convex portions provided on the rear surface 10B of the flexible solar cell module 10, or the base sheet of the PSA member is deformed into a shape corresponding to the concave and convex portions of the rear surface 10B. Therefore, the PSA member 20 is strongly bonded to the rear surface 10B. The squeegee is a kind of pallet and is made of an elastic material, such as polypropylene. In order to distribute the PSA member 20 into the concave portions of the concave and convex portions, the pressing method using the squeegee and other various kinds of methods are used. For example, the following methods may be used: a method of heating the PSA member 20 to be softened, thereby sticking the PSA member 20 into the concave and convex portions; and a method of coating or applying the PSA member 20 as a low-viscosity liquid and volatilizing a solvent or heating the PSA member 20 to increase viscosity. When the PSA member 20 is a double-sided PSA tape, particularly, the pressing method using the squeegee facilitates the pressure sensitive adhesion.

The PSA member 20 according to this embodiment is not necessarily a double-sided PSA tape. For example, instead of the step of providing the PSA member 20 on the rear surface 10B, that is, Step S104 of contacting the PSA member and Step S106 of pressing the PSA member in Fig. 3A, the PSA member including only a pressure sensitive adhesive may be applied onto at least a portion of the rear surface 10B of the flexible solar cell module 10. In this case, the PSA member 20 may be formed by, for example, an applying method using a dispenser, a calendar coating method, and a printing method, such as a screen printing method. In the forming methods, for example, the physical property (viscosity and the degree of polymerization) of the PSA member 20 or the precursor thereof and conditions (for example, the temperature) that have an effect on the physical property are suitable for coating and the PSA member 20 or the precursor thereof is formed in a layered structure. When it is necessary to adjust the conditions to be suitable for the pressure sensitive adhesion of the PSA member 20, for example, processes, such as drying and heating, are added (which are not shown). Then, for example, the release liner 22 is provided to protect the pressure sensitive adhesion surface. In this stage, the solar cell module 100 with a PSA member shown in Fig. 4A is manufactured. The PSA member 20 may not be directly formed on the rear surface 10B of the flexible solar cell module 10, but the PSA member 20 or the precursor layer thereof may be formed on the release liner 22 and the release liner 22 and the flexible solar cell module 10 may be pressed.

Returning to Fig. 3A, after the solar cell module 100 with a PSA member is completed, the subsequent process is performed without delay or after a predetermined period of time. In order to perform the subsequent process, the support surface 30F of the support member 30 is cleaned, if necessary (S108). A solvent can be used to clean the support surface 30F, if necessary. In the solar cell module 100 with a PSA member (Fig. 4A), when the release liner 22 peels off from the PSA member 20 on the rear surface 10B of the flexible solar cell module 10 (S110), the exposed pressure sensitive adhesion surface faces the clean support surface 30F and the flexible solar cell module 10 is pressed and bonded to the support member 30 (S112). In this way, the flexible solar cell module 10 is integrated with the support member 30 by the PSA member 20 and a support member integrated solar cell module 1000 is manufactured. In Step (S112) of pressing the flexible solar cell module 10, for example, a roller may be used to apply uniform pressing force.

The schematic cross-sectional view of Fig. 5 shows an aspect in which the solar cell module 100 with a PSA member is integrated with the support surface 30F of the support member 30. The PSA member 20 is a viscoelastic body and is flexible. Therefore, both the flexible solar cell module 10 and the solar cell module 100 with a PSA member are flexible. Therefore, when the solar cell module 100 with a PSA member is integrated with the support surface 30F shown in Fig. 5, a portion of the solar cell module 100 with a PSA member is a flexural portion 100C and the solar cell module 100 with a PSA member is sequentially pressed against the support surface 30F while the flexural portion 100C is extended. Although not shown in the drawings, for example, when the support surface is a curved surface, the solar cell module 100 with a PSA member is bonded in the same way as described above and the flexible solar cell module 10 is integrated while being bent along the curved surface.

Fig. 4B is a plan view illustrating the solar cell module 100 with a PSA member, as viewed from the rear surface 10B of the flexible solar cell module 10. Unlike Fig. 4A, Fig. 4B does not show the release liner 22. The PSA member 20 is arranged in any pattern on the rear surface 10B of the flexible solar cell module 10. The PSA member 20 is typically arranged in a stripe pattern as shown in Fig. 4B. The stripe pattern includes strip-shaped unit PSA members 202 that extend in the longitudinal direction of the flexible solar cell module 10 and are arranged in parallel in the width direction. The arrangement pattern of the PSA member 20 is not limited to the stripe pattern, but the PSA member 20 may be arranged in any pattern. For example, the PSA member 20 may be formed on the entire rear surface 10B or it may be formed only in a peripheral portion of the flexible solar cell module 10.

As such, in the first manufacturing method of the support member integrated solar cell module 1000, the solar cell module 100 with a PSA member (Fig. 4) is manufactured (S102 to S106 in Fig. 3A) and then the solar cell module 100 with a PSA member is integrated with the support member 30 (S108 to S112).

In the first manufacturing method of the support member integrated solar cell module shown in Fig. 3A, a process (S102 to S106) of forming the solar cell module 100 with a PSA member, which is the first half of the first manufacturing method, and a process (S108 to S112) of integrating the solar cell module 100 with a PSA member with the support, which is the second half of the first manufacturing method, may be performed by the same operator or different operators. As a typical example of the case in which the first half and the second half of the first manufacturing method are performed by the same operator, the support member 30 is, for example, a roofing material of the existing building and the worker, serving as the operator who integrates the flexible solar cell module 10 with the roof, performs all of the above-mentioned processes (S102 to S112). In this example, the operator bonds the PSA member 20 to the rear surface of the flexible solar cell module 10 to manufacture the solar cell module 100 with a PSA member (S102 to S106). Then, the operator integrates the manufactured solar cell module 100 with a PSA member with the roofing material, which is the support, using the PSA member, thereby manufacturing the support member integrated solar cell module 1000 (S108 to S112). As another typical example of the case in which the first half and the second half of the first manufacturing method are performed by the same operator, the support member 30 is, for example, a metal plate or sheet and the manufactured support member integrated solar cell module 1000 is attached to another support member (not shown). In this example, the manufacturer of the solar cell module performs all of the processes (S102 to S112) of manufacturing the support member integrated solar cell module 1000 integrated with the metal plate or sheet. In all of the examples, the method of manufacturing the support member integrated solar cell module 1000 has advantages in terms of execution. For example, the solar cell module 100 with a PSA member may be manufactured in advance by the first half (S102 to S106) of the first manufacturing method, the support member 30 may be acquired if necessary, and the second half (S108 to S112) of the first manufacturing method may be performed using the support member 30. It is possible to manufacture the support member integrated solar cell module 1000 corresponding to various kinds of purposes only by appropriately selecting the support member 30 from various viewpoints. The support member 30 is not limited to the metal plate or sheet, but it may be, for example, a roofing material. In particular, when a lightweight or flexible support member 30 is used, it is possible to maintain the entire support member integrated solar cell module 1000 to be lightweight or flexible.

As a typical example of the case in which the first half and the second half of the first manufacturing method are performed by different operators, for example, the manufacturer of the solar cell module manufactures the solar cell module 100 with a PSA member and the operator attaches the solar cell module 100 with a PSA member to the support member 30. As an example, the manufacturer of the solar cell module performs the process (S102 to S106) of manufacturing the solar cell module 100 with a PSA member to manufacture the solar cell module 100 with a PSA member (Fig. 4A), and the roofing material of the existing building or the building under construction is the support member 30. In this example, when the solar cell module 100 with a PSA member is used, the worker, who is the operator, can attach the flexible solar cell module 10 to the support member 30 (roofing material) with a simple operation. That is, it is easy to manufacture the support member (roofing material) integrated solar cell module 1000. In this example, in particular, the solar cell module 100 with a PSA member can be manufactured in the factory where the manufacturing process is strictly managed. In this case, the PSA member 20 has been reliably attached to the solar cell module 100 with a PSA member at the time when the operator acquires the solar cell module 100 with a PSA member. Therefore, the workload of the operator is reduced and it is possible to improve the reliability of the completed support member (roofing material) integrated solar cell module 1000.

Next, the second manufacturing method of the support member integrated solar cell module will be described. In the second manufacturing method of the support member integrated solar cell module shown in Fig. 3B, the PSA member 20 is formed on the support member 30 and then the flexible solar cell module 10 is integrated with the support member 30. That is, the support surface 30F of the support member 30 is cleaned, if necessary (S202). Then, the PSA member 20 is arranged on the support surface 30F of the support member 30 (S204) and the PSA member 20 is pressed so as to be reliably bonded (S206). When the rear surface 10B of the solar cell 10 is cleaned if necessary (S208), the release liner of the PSA member 20 arranged on the support surface 30F peels off and the pressure sensitive adhesion surface is exposed (S210). Then, the solar cell 100 is pressed against the support surface 30F having the exposed pressure sensitive adhesion surface thereon with the rear surface 10B facing the support surface 30F (S212). In this way, the support member integrated solar cell module 1000 (Fig. 1) is manufactured.

In the second manufacturing method, the integrated support member may be, for example, a metal plate or sheet and the manufactured support member integrated solar cell module 1000 may be attached to another support. In addition, in the second manufacturing method, for example, when the support member is a roofing material of the building, the PSA member may be arranged on the roofing material and then the flexible solar cell module may be integrated with the roofing material to manufacture a support member (roofing material) integrated solar cell module.

### [Effect of PSA member]

In each of the first and second manufacturing methods, since the PSA member 20 is used, it is possible to effectively perform a process of integrating the flexible solar cell module 10 with the support member 30. As a detailed example that directly shows this advantage, a process of integrating the flexible solar cell module 10 with the support member 30 (roofing material) using the PSA member 20, which is a double-sided PSA tape, will be described. Here, an example in which the worker, who is the operator, integrates the solar cell module 100 with a PSA member with the support member will be described. In this example, the roofing material of the building corresponds to the support member 30, the upper surface of the roofing material corresponds to the support surface 30F of the support member 30 (Fig. 1), and the worker works at the rooftop of the building. In this case, each of the first and second manufacturing methods will be described.

In the first manufacturing method (Fig. 3A), when the first half (S102 to S106 in Fig. 3A) of the first manufacturing method ends and the solar cell module 100 with a PSA member is completed, the surface of the roofing material is cleaned, if necessary (S108). Then, the solar cell module 100 with a PSA member is positioned on the upper surface of the roofing material. Then, as shown in Fig. 3A, the release liner of the double-sided PSA tape peels off (S110) and the flexible solar cell module 10 is pressed against the upper surface of the roofing material (S112).

In the second manufacturing method (Fig. 3B), first, the surface of the roofing material is cleaned, if necessary (S202). Then, the flexible solar cell module 10 is positioned on the upper surface of the roofing material. Then, as shown in Fig. 3B, the double-sided PSA tape, which is the PSA member 20, is attached to the upper surface of the roofing material (S204 and S206) and the release liner (not shown) of the double-sided PSA tape, which is the PSA member 20, peels off (S210). Then, the flexible solar cell module 10 is arranged and pressed against the double-sided PSA tape (S212).

When the PSA member is used, in each of the first and second manufacturing methods, a process for integrating the support member (roofing material) integrated solar cell module is completed with a simple operation. The worker who works at the rooftop of the building does not need to perform a precise operation as in adhesion, wait for a long time until the adhesive is cured, and perform an additional operation, such as an operation of temporarily fixing the flexible solar cell module during the curing of the adhesive or an operation of removing the adhesive. In each of the first and second manufacturing methods, when the PSA member is used, it is possible to effectively perform a process of integrating the flexible solar cell module 10 with the support member 30.

### [Selection of PSA member]

Next, the PSA member used in this embodiment will be described. As described above, the PSA member used in this embodiment is a single-layer or multi-layer film or layer that is made of any material including a pressure sensitive adhesive and has an arbitrary thickness. Therefore, the PSA member may have a structure in which the pressure sensitive adhesive is provided on both surfaces of a base sheet.

A material used as the PSA member according to this embodiment is not particularly limited. In general, the material is selected from, for example, an acrylic foam-based material, a butyl rubber-based material, a solvent-drying acryl-based material, a polyethylene foam-based material, and a polyurethane foam-based material. In the list of the materials, the materials of the base sheet are non-attributively arranged. In addition, the pressure sensitive adhesive to be combined with the base sheet may be arbitrarily selected. For example, the acrylic foam-based PSA member may be formed by arranging an acrylic pressure sensitive adhesive with a controlled degree of polymerization on both surfaces of the base sheet made of acrylic resin foam. Similarly, the butyl rubber PSA member may be formed by applying an acrylic pressure sensitive adhesive onto both surfaces of the base sheet made of butyl rubber foam. In addition, even when the PSA member is formed by only the pressure sensitive adhesive without using a base sheet, the pressure sensitive adhesive is arbitrarily selected.

In this embodiment, dynamic viscoelasticity is measured in order to select the PSA member. It is noted that the dynamic viscoelasticity of the PSA member is measured. For example, when the PSA member includes only a pressure sensitive adhesive, the dynamic viscoelasticity of the PSA member including only the pressure sensitive adhesive is measured. When the PSA member has a laminated structure of a pressure sensitive adhesive, a base sheet, and a pressure sensitive adhesive, the dynamic viscoelasticity of the PSA member is measured using a sample extracted from the PSA member while the laminated structure is maintained.

As described above, the storage modulus G' is used as the measured value of dynamic viscoelasticity for selecting the PSA member. The storage modulus G' is measured by a rheometer while the measurement temperature is controlled. The range of the measurement temperature is determined considering the operating temperature range of the flexible solar cell module.

The range of the storage modulus G' used to select the PSA member is determined on the basis of the test result of joint strength. This is because the test result of joint strength can be predicted by the storage modulus G' of the PSA member according to the examination result of the inventors of the invention. First, the joint strength test will be described in order to clarify the relationship between the numerical range of the storage modulus G' and the test result of the joint strength.

### [Test of joint strength -test conditions-]

In this embodiment, the PSA member is selected on the basis of the storage modulus G' of dynamic viscoelasticity. In order to determine the range of the storage modulus G' for selecting the PSA member, the numerical relationship between the joint strength and the storage modulus G' is examined. The joint strength is measured by a test piece including a flexible solar cell module, a support, and a PSA member for bonding the flexible solar cell module and the support. The test items of the joint strength are 180-degree peel strength and tensile shear strength.

In order to perform the test by the measurement of the 180-degree peel strength and the tensile shear strength, environmental conditions for testing each strength value and the minimum value (reference value) in each environmental condition are set. The environmental conditions and the reference value of strength are set according to the actual use conditions of the support member integrated solar cell module. Specifically, in this embodiment, the temperature range in which the bonding of the support member integrated solar cell module is maintained is from - 20°C to 85°C. For the joint strength of the bonding of the support member integrated solar cell module, the minimum value (the reference value) of the 180-degree peel strength is 1.2 N/cm and the minimum value of the tensile shear strength is 3 N/cm². In the selected PSA member, both the 180-degree peel strength and the tensile shear strength need to be equal to or more than the reference value in the above-mentioned temperature range.

The test piece for measuring the joint strength is bonded by various kinds of PSA members so as to have the same structure as the support member integrated solar cell module 1000 shown in Fig. 1. Specifically, of two adherends bonded by the PSA member, one adherend (referred to as a first piece) is cut out from the actual flexible solar cell module and the other adherend (referred to as a second piece) is cut out from the actual support.

Specifically, the first piece is cut out from the flexible solar cell module with a thickness (total thickness) of 0.85 mm. A back sheet (corresponding to the fluorine-based resin sheet 18) that is made of ethylene-tetrafluoroethylene copolymer (ETFE) is exposed from the rear surface of the flexible solar cell module. Concave and convex portions with a depth of 130 µm are formed on the rear surface of the flexible solar cell module and a plasma treatment is performed thereon as a pre-process for pressure sensitive adhesion. As the second piece, a fluorine-coated galvanized steel plate (hereinafter, referred to as a "galvanized steel plate") with a thickness of 2.0 mm is used. Since the first piece and the second piece are examples of the flexible solar cell module 10 and the support member 30 included in the actual support member integrated solar cell module 1000, they will be described appropriately using the reference numerals shown in Fig. 1.

The test piece is prepared by the first manufacturing method (Fig. 3A). That is, the PSA member comes into contact with the entre bonding region of the first piece (flexible solar cell module 10) and then the PSA member is arranged on the rear surface 10B of the first piece. At that time, the PSA member is sufficiently pressed by a squeegee from the upper side of the release liner such that it gets into the concave portions in the rear surface 10B and there is no gap or void. Then, the second piece (galvanized steel plate) is placed on the upper surface of a flat plate that is arranged in parallel, with the support surface facing upward. Then, the release liner peels off and the pressure sensitive adhesion surface comes into contact with the support surface. Then, the first piece is arranged above the second piece (support member 30) with the PSA member facing downward. Then, a compaction roller (mass: 9 kg) is reciprocated once without adding a load other than the mass of the compaction roller, thereby pressing a light receiving surface of the first piece against the second piece. In order to measure the joint strength of the test piece under the use conditions close to the actual use conditions, a process of waiting until the bonding of the PSA member is stabilized, that is, curing is performed. In the curing, the test piece is maintained in parallel for three days at room temperature (20°C to 25°C) without applying any load. It is confirmed that, when curing is performed for three days, a variation in bonding characteristics is sufficiently negligible. The first piece (flexible solar cell module) and the second piece (galvanized steel plate) have a size of 7.5 mm × 25 mm in the 180-degree peel strength test and have a size of 7.5 mm × 10 mm in the tensile shear strength test. The length of each of the test pieces in the width direction is 7.5 mm. In the 180-degree peel strength test, the first piece (flexible solar cell module) is folded back at 180 degrees and is set in a tester. In this way, the test pieces for each strength test that simulate the support member integrated solar cell module are manufactured.

The test pieces for joint strength test are manufactured for various kinds of PSA members and the relationship between the storage modulus G' and the joint strength is examined on the basis of the test result. Here, three kinds of PSA members (hereinafter, referred to as PSA members A, B, and C) will be described as an example. In the PSA member A, the base sheet is made of an acrylic foam-based material. In the PSA member B, the base sheet is made of a butyl rubber-based material. In the PSA member C, the base material is made of an acrylic foam-based material different from that forming the base material of the PSA member A. In each of the PSA members A to C, the pressure sensitive adhesive applied onto both surfaces of the base sheet is made of the same material with the same thickness. However, the pressure sensitive adhesives used in the PSA members A, B, and C may be different from each other. A plurality of test pieces is manufactured for each of the PSA members A, B, and C. The test pieces used in the PSA members A, B, and C are collectively referred to as Example 1, Comparative example 1, and Comparative example 2, respectively. The average joint strength of all of the test pieces in the same PSA member under each condition is used as the measurement result. The number of test pieces in each of Example 1, Comparative example 1, and Comparative example 2 is 3. The 180-degree peel strength test and the tensile shear strength test are performed at an atmospheric pressure of 1 at a temperature of -20°C and 85°C and the tension rate in each test is 100 mm/min.

### [Joint strength test -test result-]

The test result will be described. The tensile shear strength of each PSA member was more than the reference value (3 N/cm²) at each temperature except for tensile shear strength of the PSA member B (Comparative example 1) at a temperature of 85°C. Specifically, at a temperature of -20°C, in all of Example 1 and Comparative examples 1 and 2, sufficient tensile shear strength more than the reference value (3 N/cm²) was obtained. At a temperature of 85°C, in Example 1 and Comparative example 2, the tensile shear strength was more than the reference value, but in Comparative example 1 (butyl rubber-based PSA member B), the PSA member was deformed by heat and the tensile shear strength was less than the reference value (3 N/cm²)_{.}

For the 180-degree peel strength, the result shown in Table 1 was obtained.

**[Table 1]**

| Measurement of 180-degree peel strength | | | | |
|---|---|---|---|---|
| | -20°C | | 85°C | |
| | 180-degree peel strength (N/cm) | Peeling action | 180-degree peel strength (N/cm) | Peeling action |
| Example 1 (PSA member A) | 8.5 | Interfacial peeling | 1.6 | Interfacial peeling |
| Comparative example 1 (PSA member B) | 0* | Instant peeling | 0.3 | Cohesion failure |
| Comparative example 2 (PSA member C) | 0* | Instant peeling | 1.6 | Interfacial peeling |

| | | | | |
|---|---|---|---|---|
| * 180-degree peel strength is zero due to instant peeling | | | | |

In Example 1, the value of 180-degree peel strength at a temperature of -20°C was 8.5 N/cm more than the reference value (1.2 N/cm) and the peeling action was peeling at the interface between the first piece (flexible solar cell module) and the PSA member. Hereinafter, this peeling action is referred to as "interfacial peeling." However, in Comparative examples 1 and 2, when the end of the bonding region of the test piece started to peel off, the entire bonding region instantly peeled off from the interface between the PSA member and the second piece (galvanized steel plate). Hereinafter, this peeling aspect is referred to as "instant peeling." In Table 1, in Comparative example 1 and Comparative example 2, the value of 180-degree peel strength is 0 N/cm. The value of the 180-degree peel strength for the instant peeling is 0 N/cm on the basis of the peeling action of the PSA member over time in the measurement of the 180-degree peel strength. That is, in the case of the interfacial peeling, in each stage of the measurement of the 180-degree peel strength, the force is the maximum at the time when the bonding region starts to peel off. In the action after that time, the peeling of the bonding region progresses while the force is changed. Finally, the entire bonding region peels off and the force is the minimum (zero). In contrast, in the case of the instant peeling, similarly, the force is the maximum at the time when the bonding region starts to peel off. However, at the moment when the bonding region starts to peel off, the entire bonding region peels off. Therefore, there is no stage in which the peeling of the bonding region is in progress. In both cases, the maximum value of force is not used as the value for the 180-degree peel strength, but the average value of the force when the peeling of the bonding region is in progress is used as the value for the 180-degree peel strength. In the interfacial peeling, the average value can be determined by measurement. In the instant peeling, since there is no stage capable of determining the average value, the 180-degree peel strength is 0 N/cm.

In Example 1 and Comparative example 2, the value of the 180-degree peel strength at a temperature of 85°C was 1.6 N/cm. In Comparative example 1, the value of the 180-degree peel strength was 0.3 N/cm. In Example 1 and Comparative example 2 in which the acrylic foam-based PSA member was used, the value of the 180-degree peel strength was more than the reference value (1.2 N/cm). However, in Comparative example 1 in which the butyl rubber-based PSA member was tested, the value of the 180-degree peel strength was 0.3 N/cm less than the reference value due to the influence of heat, similar to the tensile shear strength. In Example 1 and Comparative example 2, the peeling action at a temperature of 85°C was the interfacial peeling in which the interface between the first piece (flexible solar cell module) and the PSA member peeled off. In Comparative example 1, the butyl rubber-based base sheet was damaged, which resulted in cohesion failure.

### [Measurement of dynamic viscoelasticity -measurement conditions-]

Next, the measurement of dynamic viscoelasticity performed in contrast with the measurement result of the joint strength test will be described. The measurement of the dynamic viscoelasticity is performed using the PSA members A, B, and C used in Example 1, Comparative example 1, and Comparative example 2 as samples. The dynamic viscoelasticity is measured by a rheometer (Paar Physica UDS200). The measurement temperature range is from -30°C to 120 ° C including the temperature of -20 ° C and 85°C where the joint strength is tested. The rage of temperature increase is 5°C/min. The PSA members are fixed by jigs (flat plates), which is called MP306, with a diameter of 25 mm with a gap therebetween and then the dynamic viscoelasticity thereof is measured. A measurement gap, that is, the amount of pressing of the upper and lower flat plates that apply shear force is 20% of the thickness of each PSA member. That is, in the measurement of the dynamic viscoelasticity, the PSA member sample is interposed and pressed by the flat plates such that the thickness of the pressed PSA member sample is 80% of that before the PSA member sample is pressed. The thickness of the PSA member is measured by a micrometer. In the detailed measurement setup, a measurement jig having a circular shape with a diameter of 25 mm is used and the frequency of vibration applied is 1.0 Hz.

### [Measurement of dynamic viscoelasticity -measurement result-]

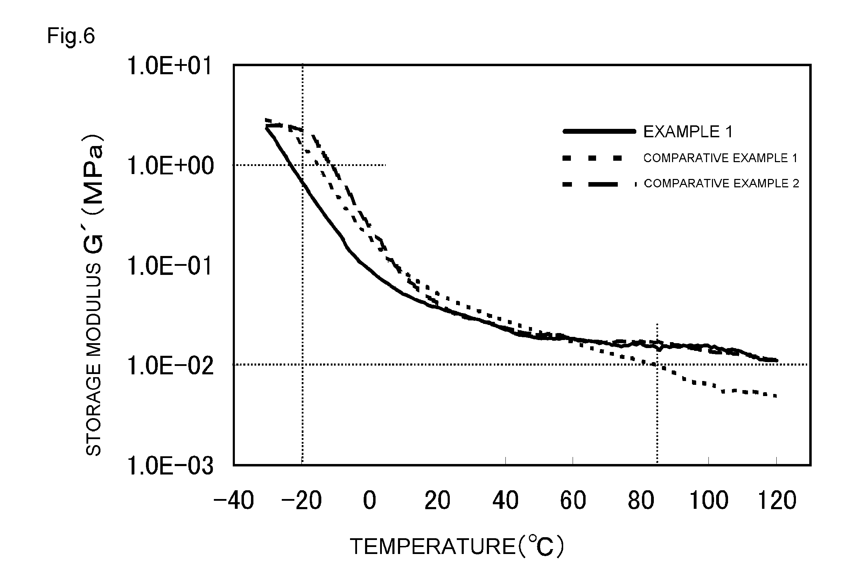

Fig. 6 is a graph illustrating the storage modulus G' of each sample of the PSA member at each temperature which is obtained by this measurement. In all of the measured PSA members, the storage modulus G' is reduced as the temperature increases. Therefore, the maximum value of the storage modulus G' in the measurement temperature range is obtained at the lower limit temperature (-20 °C) and the minimum value thereof is obtained at the upper limit temperature (85°C). Among the measured values of the storage modulus G' shown in Fig. 6, the values of the storage modulus G' at-20°C and 85°C, which are the lower and upper limits of the temperature range of the use conditions, the state of the physical property at each temperature are arranged in Table 2. The state of each PSA member at each temperature shown in Table 2 is based on the value of the storage modulus G' at each temperature shown in Fig. 6 and the value of tan δ (not shown) and each PSA member is estimated to be in any one of a glass state, a rubber state, and a fluid state. In the estimation, the peeling action in the peeling test is not considered.

**[Table 2]**

| Storage modulus G' | | | | |
|---|---|---|---|---|
| | -20°C | | 85°C | |
| | Storage modulus G' (Mpa) | State | Storage modulus G' (Mpa) | State |
| PSA member A (Example 1) | 0.69 | Rubber state | 0.02 | Rubber state |
| PSA member B (Comparative example 1) | 1.6 | Glass state | 0.009 | Fluid state |
| PSA member C (Comparative example 2) | 1.9 | Glass state | 0.02 | Rubber state |

As shown in Table 2, the storage modulus G' of the PSA member A used in Example 1 was 0.69 MPa at -20°C and 0.02 MPa at 85°C. The PSA member A was in the rubber state in the entire temperature range of -20°C to 85°C. In contrast, the storage modulus G' of the PSA member A used in Comparative example 1 was 1.6 MPa at -20°C and 0.009 MPa at 85 ° C. The PSA member B was in the glass state at -20°C and was in the fluid state at 85°C. The storage modulus G' of the PSA member C used in Comparative example 2 was 1.6 MPa at-20°C and 0.02 MPa at 85°C. The PSA member C was in the glass state at -20°C and was in the rubber state at 85°C.

### [Relationship between joint strength and storage modulus G']

When the test result of the joint strength is compared with the measurement result of the dynamic viscoelasticity, the following findings are obtained from the relationship between the joint strength of the test piece and the storage modulus G' of the PSA member. These findings are mainly obtained from the test result of the 180-degree peel strength of each test piece shown in Table 1 and the measurement result of the storage modulus G' of each PSA member shown in Table 2.

A first finding is that the peeling action and joint strength of the test piece in the joint strength test can be predicted from the storage modulus G' of the PSA member. That is, the PSA member (PSA members B and C) having a large storage modulus G' at-20°C peels off by the instant peeling in the 180-degree peel strength test of the test piece (Comparative examples 1 and 2) using the PSA member and the strength is less than the reference value. In contrast, the PSA member (PSA member A) having the storage modulus G' less than that of the PSA members B and C at-20°C peels off by the interfacial peeling in the 180-degree peel strength test of the test piece (Example 1) and the strength is more than the reference value.

A cohesion failure occurs in the PSA member (PSA member B) having a small storage modulus G' at 85°C in the 180-degree peel strength test of the test piece (Comparative example 1) using the PSA member and the strength of the PSA member is equal to or less than the reference value. Although not shown in the table, in the tensile shear strength test at 85°C, the PSA member B is in the fluid state and the strength thereof does not reach the reference value. In contrast, the PSA member (PSA members A and C) having a storage modulus G' more than a given value at 85°C peels off by the interfacial peeling in the 180-degree peel strength test of the test piece (Example 1 and Comparative example 2) and the strength thereof is more than the reference value. As such, the peeling action and strength of the test piece in the joint strength test can be predicted on the basis of the value of the storage modulus G' of the PSA member.

A second finding is more qualitative and general than the first finding. The second finding is that, even though the joint strength of the test piece using the actual flexible solar cell module or support member needs to be measured, the joint strength can be predicted from the value of the storage modulus G' of only the PSA member except for the flexible solar cell module or the support member. That is, the value of the storage modulus G' of the PSA member is not directly related to the flexible solar cell module and the support member. However, as in the first finding, it is possible to predict the joint strength of the test piece using the actual flexible solar cell module or support member. This shows that an essential factor determining the joint strength is not related to the flexible solar cell module or the support member, but is related to the physical property of the PSA member, particularly, the storage modulus G'.

The range in which the second finding is determined to be correct is strictly only the range of the conditions where the measurement according to this embodiment of the invention is performed. In addition, the measurement result of this embodiment of the invention is obtained under relatively good conditions. This is because the adherend, which is a test target, is limited to the rear surface of the flexible solar cell module on which the concave and convex portions are formed and which is subjected to a plasma treatment and the support surface of the galvanized steel plate. However, there are conditions that can be substantially predicted by the value of the storage modulus G', which is a property peculiar to the PSA member, which clearly shows that the joining force by adhesion is greatly affected by the storage modulus G' of the PSA member.

The test result and the measurement result will be described considering the first and second findings. First, it is understood that the value of the 180-degree peel strength in Example 1 is more than the reference value at -20°C and 85°C since the PSA member A used in Example 1 has a sufficient storage modulus G' to make the PSA member A in the rubber state at -20°C and 85°C. In Comparative example 1, it is understood that the 180-degree peel strength at -20°C becomes instant peeling and both the 180-degree peel strength and the tensile shear strength are reduced at 85°C since the storage modulus G' of the PSA member B is sufficiently large to make the PSA member B in the glass state at-20°C and make the PSA member B in the fluid stat at 85°C. In Comparative example 2, it is understood that the 180-degree peel strength at -20°C becomes instant peeling and the strength equal to or more than the reference value is obtained at 85°C since the storage modulus G' of the PSA member C is sufficiently large to make the PSA member C in the glass state at-20°C and make the PSA member C in the rubber stat at 85°C. There is no inconsistency between these understandings. These understandings are consistent with the findings that the joining force by adhesion is determined by the storage modulus G' of the PSA member.

The inventors consider that the bonding performance of the PSA member having the storage modulus G' within a given range is maintained because of the stress deconcentration and cohesion of the PSA member having the storage modulus G' within the range. The stress deconcentration means that the PSA member is deformed with the relative movement of the adherend (the flexible solar cell module and the support) and follows the movement, thereby dispersing stress. The stress deconcentration prevents the concentration of stress. The cohesion means that the PSA member maintains its shape.

### [Selection of PSA member on the basis of storage modulus G']

A detailed knowledge related to a quantitative or numerical standard for selecting the PSA member is acquired from the above-mentioned findings. That is, in order to make the joint strength of the test piece equal to or more than the reference value, a PSA member having a storage modulus G' that is from 0.02 MPa to 0.7 MPa which is obtained by measurement under the use conditions needs to be selected. As an example of the use conditions, the temperature range is from -20°C to 85°C. As another condition, for example, a standard atmospheric pressure corresponding to the use conditions is 1. That is, the use conditions may be selected so as to include, for example, the actual operation conditions of the support member integrated solar cell module 1000 or the actual operation conditions of the flexible solar cell module 10. In addition, instead of the operation conditions, any conditions where the PSA member shows a sufficient bonding performance, such as the storage conditions, installation conditions, and warranty conditions of the support member integrated solar cell module 1000, may be used as the use conditions.

The meaning of designating the numerical range of the storage modulus G' on the basis of the test result and the measurement result shown in Tables 1 and 2 will be described with reference to, particularly, stress deconcentration and cohesion. First, the problem is stress deconcentration at a temperature of-20°C in the test according to this embodiment. In the test result of the 180-degree peel strength at -20 °C shown in Table 1, in Example 1 using the PSA member A, there is no problem in the stress deconcentration and interfacial peeling is observed. However, in Comparative examples 1 and 2 respectively using the PSA members B and C, the stress deconcentration is insufficient and instant peeling is observed. For the value of the storage modulus G' obtained from the measurement result at-20°C shown in Table 2 which corresponds to the above-mentioned test result, the storage moduli G' of the PSA members B and C (1.6 MPa and 1.9 MPa) are significantly more than that of the PSA member A (0.69 MPa). When the test result and the measurement result are arranged from the viewpoint of stress deconcentration, a storage modulus G' of about 1.6 MPa for stress deconcentration, which is the upper limit, is too large. The upper limit of the storage modulus G' for stress deconcentration is preferably about 0.69 MPa and more preferably about 0.7 MPa.

The problem is cohesion at 85°C in the test according to this embodiment. In the test result of the 180-degree peel strength at 85°C shown in Table 1, in Example 1 and Comparative example 2 respectively using the PSA members A and C, there is no problem in cohesion and interfacial peeling is observed. However, in Comparative example 1 using the PSA member B, cohesion is insufficient and a cohesion failure is observed. For the value of the storage modulus G' obtained from the measurement result at 85°C shown in Table 2 which corresponds to the above-mentioned test result, the storage modulus G' of the PSA member B (0.009 MPa) is significantly less than those of the PSA members A and B (0.02 MPa). From the test result and the measurement result, a storage modulus G' of 0.009 MPa for cohesion, which is the lower limit, is too small. The lower limit of the storage modulus G' for cohesion is preferably about 0.02 MPa.

That is, the preferable numerical range of the storage modulus G' of the PSA member capable of expecting both sufficient stress deconcentration and sufficient cohesion is from 0.02 MPa to 0.7 MPa under the use conditions of the flexible solar cell module.

Each of the PSA members A to C according to this embodiment includes a base sheet. In this case, the storage modulus G' of the PSA member is greatly affected by the storage modulus G' of the base sheet that accounts for most of the thickness. The inventors consider that the storage modulus G' of the entire PSA member is determined by the storage modulus G' of the base sheet. However, it is considered that, even when a PSA member with another structure is used, the bonding performance is maintained when the storage modulus G' of the entire PSA member capable of ensuring the stress deconcentration and the cohesion is obtained. For example, it is considered that, even when the PSA member includes only an adhesive, the joint strength is determined by the storage modulus G' of the entire PSA member (adhesive).

In addition, the use conditions according to this embodiment of the invention are not necessarily the given conditions. Environmental conditions where the storage modulus G' of the PSA member is from 0.02 MPa to 1 MPa may be defined as the use conditions of the support member integrated solar cell module 1000.

### [Adjustment of PSA member by thickness]

In the joint strength test that forms the basis of determining the numerical range of 0.02 MPa to 0.7 MPa of the storage modulus G', the thickness (thickness that does not include the thickness of the release liner) of the PSA members A, B, and C is from 0.5 mm to 1.5 mm. When the PSA member has a thickness in the above-mentioned range, it is considered that the PSA member having the storage modulus G' in the above-mentioned numerical range is suitable for the purpose of the invention. When the thickness of the PSA member is greatly changed, it is preferable to select a PSA member with a storage modulus G' in another numerical range. For example, for a PSA member with a thickness of T mm (T is a real number greater than 0), the numerical range of the storage modulus G' is preferably from 0.02 MPa to T × 0.7 MPa. A storage modulus G' of T × 0.7 MPa, which is the upper limit, means that the upper limit of 0.7 MPa is changed according to the thickness ratio of 1 : T when the thickness of the PSA member is from 0.5 mm to 1.5 mm. The representative value of the thickness, which is from 0.5 mm to 1.5, of the PSA member is 1 mm.

In this example, the lower limit, 0.02 MPa, of the numerical range is not changed, but only the upper limit is changed depending on the thickness of the PSA member. The reason is as follows. First, the lower limit (0.02 MPa) of the numerical range of the storage modulus G' is a boundary value determining whether the PSA member is in the rubber state or in the fluid state. The lower limit of the numerical range is a boundary value that determines whether bonding by the PSA member is maintained or a cohesion failure occurs in the PSA member. When a cohesion failure occurs, bonding is not maintained regardless of the thickness. Therefore, the lower limit is not changed depending on the thickness of the PSA member. In contrast, the upper limit, 0.7 MPa, of the numerical range of the storage modulus G' is a boundary value determining whether the state is an instant peeling state or not. That is, the upper limit of the numerical range of the storage modulus G' determines whether the PSA member can follow the relative deformation of adherends (the flexible solar cell module and the support) to be bonded to both surfaces. Even when the adherends bonded to both surfaces of the PSA member are deformed by the same amount relative to each other, the amount of shear strain occurring in the PSA member due to the deformation is inversely proportional to the thickness of the PSA member. When the PSA members with different thicknesses have the same storage modulus G', the value of the shear stress occurring in the PSA member due to the same displacement is inversely proportional to the thickness. When the storage modulus G' is proportional to the thickness and the adherends on both surfaces of the PSA members are displaced by the same amount relative to each other, the same shear stress is applied to the PSA member. Therefore, it is preferable that the upper limit, 0.7 MPa, of the storage modulus G' be corrected to T × 0.7 MPa so as to be proportional to the thickness.

### [Selection of PSA member from other viewpoints]

When the PSA member is selected on the basis of the storage modulus G' from the viewpoint of joint strength, other viewpoints may be added to the guideline for selecting the PSA member. Specifically, since the flexible solar cell module is used outdoors for a long time, for example, weather resistance is added to the selection of the PSA member. From the viewpoint of weather resistance, it is preferable to use a PSA member including, for example, an acrylic foam-based base sheet.

### [Selection of support member]

Any support member may be used as along as it can be bonded to the PSA member. However, there is a support member suitable for bonding by the PSA member. Specifically, it is preferable to use a support member having a support surface with a surface free energy, that is, a critical surface tension of 30 mJ/m² (30 mN/m or 30 dyne/cm) or more. When the surface free energy of the support surface is less than 30 mJ/m², the pressure sensitive adhesive of the PSA member is less likely to be wet with respect to the support surface. As a result, joint strength is likely to be reduced. In addition, when the surface free energy of the support surface is 30 mJ/m², the selection of the PSA member suitable for the support surface with a surface free energy of less than 30 mJ/m² is limited. Therefore, the support member having a support surface with a surface free energy of 30 mJ/m² or more is preferable. When the surface of the flexible solar cell module is contaminated, in some cases, the joint strength according to the related art is not obtained. In this case, it is preferable that the surface of the support member be cleaned with, for example, ethanol or acetone and then the pressure sensitive adhesive be bonded to the surface member.

### <First embodiment: Modification 1>

This embodiment includes the selection of the PSA member based on the findings described in this embodiment. This is because the PSA member selected in this way contributes to achieving the support member integrated solar cell module or the solar cell module with a PSA member. Therefore, the PSA member according to this embodiment of the invention includes a PSA member for a solar cell module that is arranged on the rear surface of the solar cell module opposite to the light receiving surface so as to cover at least a portion of the rear surface and has a storage modulus G' from 0.02 MPa to 0.7 MPa under the use conditions of the flexible solar cell module. The use conditions of the flexible solar cell module may be, for example, from -20°C to 85°C.

### <First embodiment: Modification 2>

In this embodiment, the detailed structure of the adherends (the first piece and the second piece) used to manufacture the test piece in the joint strength test is limited. Therefore, the findings or conclusion is likely to be affected by the detailed structure. In particular, when attention is paid to the test piece, interfacial peeling occurs only at the interface of the first piece (flexible solar cell module). Therefore, in order to find more preferable bonding conditions, the inventors examined factors that changed the joint strength depending on, particularly, the state of the rear surface of the first piece among the adherends of the test piece. The examination result proved that there was a preferable numerical range of the depth of the concave and convex portions provided on the rear surface of the flexible solar cell module which was used as the first piece. In addition, the tensile shear strength was separately tested. As a result, the tensile shear strength was more than the reference value (3 N/cm²) under all conditions. Therefore, next, only the 180-degree peel strength will be described in the test for the joint strength that varies depending on the concave and convex portions on the rear surface.

Table 3 shows the measurement result of the 180-degree peel strength at-20°C and 85°C when the depth of the concave and convex portions provided on the rear surface of the first piece (flexible solar cell module) is changed. The concave and convex portions correspond to the concave and convex portions provided on the rear surface 10B of the flexible solar cell module 10 shown in Fig. 2. Examples 2 to 5 are groups of test pieces in which the depths of the concave and convex portions provided on the rear surfaces of the flexible solar cell modules serving as the first pieces are different from each other. That is, in Examples 2 to 5, the depths of the concave and convex portions provided on the back sheets made of ETFE, which are provided on the rear surfaces of the flexible solar cell modules serving as the first pieces, are 0 µm, 50 µm, 130 µm, and 200 µm, respectively. In each of Examples 2 to 5, the thickness (total thickness) of the flexible solar cell module serving as the first piece is 0.85 mm. The test piece has a structure in which the rear surface of the first piece on which the concave and convex portions are formed is bonded to the second piece (galvanized steel plate) by the PSA member A (acrylic foam-based pressure sensitive adhesive), similar to the test piece in the 180-degree peel strength test shown in Table 1. The shape of the bonding region between the first piece and the second piece and the bonding conditions of each test piece are the same as those shown in Table 1. Therefore, the test piece included in Example 4 shown in Table 3 is manufactured under the same conditions as those where the test piece shown in Table 1.

**[Table 3]**

| | | -20°C | | 85°C | |
|---|---|---|---|---|---|
| | Depth of concave and convex portions (µm) | 180-degree peel strength (N/cm) | Peeling action | 180-degree peel strength (N/cm) | Peeling action |
| Example 2 | 0 | 6.4 | Interfacial peeling | 1.2 | Interfacial peeling |
| Example 3 | 50 | 7.4 | Interfacial peeling | 1.4 | Interfacial peeling |
| Example 4 | 130 | 8.5 | Interfacial peeling | 1.6 | Interfacial peeling |
| Example 5 | 200 | 6.4 | Interfacial peeling | 1.2 | Interfacial peeling |

The value of the depth of the concave and convex portions is calculated from the rear surface of the flexible solar cell module serving as the first piece in each of Examples 2 to 5, using the height profile of the rear surface measured by a step profiler. Specifically, in the height profile, the difference between the average value of the top of the convex portion of the concave and convex portions and the average value of the height of the bottom of the concave portion is used as the depth of the concave and convex portions. That is, the depth of the concave portion is defined by the gap between the concave portions 10D that press the rear surface 10B against a flat plate.

As shown in Table 3, the peeling actions of all of the test pieces are interfacial peeling under the experiment conditions. When it is considered that the PSA member A is in the rubber state in the above-mentioned temperature range (Table 2), both the stress deconcentration and the cohesion are obtained in the experiments shown in Table 3. That is, this result proves that the bonding performance of the PSA member A is good.

However, the value of the 180-degree peel strength is affected by the depth of the concave and convex portions shown in Table 3. In Example 2 and Example 5 in which the depths of the concave and convex portions are 0 µm and 200 µm, the 180-degree peel strength at 85°C is equal to the reference value (1.2 N/cm). In contrast, in Example 3 and Example 4 in which the depths of the concave and convex portions are 50 µm and 130 µm, the 180-degree peel strength at 85°C is significantly more than the reference value.

The inventors consider that the dependence of the 180-degree peel strength on the depth of the concave and convex portions has a mountain shape due to a change in the effective bonding area and the occurrence of a pressure sensitive adhesion gap caused by an increase in the number of concave and convex portions. First, in a flexible solar cell module having a smooth rear surface without an uneven portion, the contact area of the pressure sensitive adhesive of the PSA member is a bonding area. When the depth of given concave and convex portions is small, the pressure sensitive adhesive gets into the concave portions along a locally inclined plane that is formed by the concave and convex portions and the effective bonding area increases, which results in an increase in joint strength. However, the depth of the concave and convex portions is too large, a different situation occurs. The pressure sensitive adhesive is not widely spread to the concave portion of the concave and convex portions, but a gap or void occurs between the PSA member and the uneven surface. The gap or void reduces the effective bonding area. Therefore, in the flexible solar cell module in which the depth of the concave and convex portions provided on the rear surface is too large, the joint strength is reduced. As such, from the viewpoint of joint strength, there is a preferable range of the depth of the concave and convex portions provided on the rear surface of the flexible solar cell module. The range is from 50 µm to 130 µm. When the depth of the concave and convex portions provided on the rear surface of the flexible solar cell module is set in the above-mentioned range, the flexible solar cell module and the support member are strongly bonded by the PSA member selected on the basis of the storage modulus G' so as be integrated with each other.

The embodiments of the invention have been described in detail above. The above-described embodiments and examples of the invention are illustrative, but the invention is not limited thereto. The scope of the invention is determined on the basis of the following claims. In addition, modifications that include other combination of the above-described embodiments and are within the scope of the invention are also included in the claims.

The invention provided a solar cell module with a PSA member and a support member integrated solar cell module and contributes to the spreading of photovoltaic facilities using the solar cell module.
Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A solar cell module comprising:
a flexible solar cell module; and
a pressure sensitive adhesive member that is provided on a rear surface of the flexible solar cell module opposite to a light receiving surface so as to cover at least a portion of the rear surface,
wherein a storage modulus G' of the pressure sensitive adhesive member is from 0.02 MPa to 0.7 MPa under the use conditions of the flexible solar cell module.

2. The solar cell module according to claim 1,
wherein a temperature range of the use conditions is from -20°C to 85°C.

3. The solar cell module according to claim 1 or 2,
wherein concave and convex portions are formed on the rear surface of the flexible solar cell module.

4. The solar cell module according to claim 3,
wherein the depth of the bottom of the concave and convex portions is from 50 µm to 130 µm.

5. The solar cell module according to at least one of claims 1 to 4,
wherein the solar cell module is a support member integrated solar cell module comprising a support member including a support surface;
wherein the flexible solar cell module includes the light receiving surface and the rear surface opposite to the light receiving surface; and
the pressure sensitive adhesive member is provided in at least a portion of the rear surface,
wherein the flexible solar cell module and the support member are integrated with each other by the pressure sensitive adhesive member with the rear surface facing the support surface.

6. The solar cell module according to claim 5,
wherein the support surface is a curved surface.

7. A method of manufacturing a solar cell module, comprising:
arranging a pressure sensitive adhesive member on a rear surface of a flexible solar cell module opposite to a light receiving surface so as to cover at least a portion of the rear surface,
wherein a storage modulus G' of the pressure sensitive adhesive member is from 0.02 MPa to 0.7 MPa under the use conditions of the flexible solar cell module.

8. The method of manufacturing a solar cell module according to claim 7,
wherein a temperature range of the use conditions is from -20°C to 85 °C.

9. The method of manufacturing a solar cell module according to claim 7 or 8,
wherein concave and convex portions are formed on the rear surface of the flexible solar cell module, and
the arrangement of the pressure sensitive adhesive member includes pressing the pressure sensitive adhesive member against the rear surface using a squeegee such that the pressure sensitive adhesive member gets into the bottom of the concave and convex portions.

10. The method of manufacturing a solar cell module with a pressure sensitive adhesive member according to claim 9,
wherein the depth of the bottom of the concave and convex portions is from 50 µm to 130 µm.

11. A method of manufacturing a solar cell module according to at least one of claims 7 to 10, comprising:
providing a support member
arranging the solar cell module including the pressure sensitive adhesive member that is provided on the rear surface of the flexible solar cell module opposite to the light receiving surface so as to cover at least a portion of the rear surface such that the pressure sensitive adhesive member is exposed and the exposed pressure sensitive adhesive member faces a support surface of the support member; and
pressing the solar cell module with the pressure sensitive adhesive member against the support member.

12. A method of manufacturing a solar cell module according to at least one of claims 7 to 11, wherein
the pressure sensitive adhesive member is arranged on a support surface of a support member;
the flexible solar cell module is arranged relative to the exposed pressure sensitive adhesive member such that at least a portion of the rear surface of the flexible solar cell module opposite to the light receiving surface comes into contact with the pressure sensitive adhesive member; and
the solar cell module is pressed with the pressure sensitive adhesive member against the support member.

13. The method of manufacturing a solar cell module according to at least one of claims 7 to 12,
wherein concave and convex portions are formed on the rear surface of the flexible solar cell module.

14. The method of manufacturing a solar cell module according to claim 13,
wherein the depth of the bottom of the concave and convex portions is from 50 µm to 130 µm.

15. The method of manufacturing a solar cell module according to at least one of claims 11 to 14,
wherein the support surface is a curved surface.

16. The method of manufacturing a solar cell module according to at least one of claims 11 to 15,
wherein the support member is a roofing material of a building.
